# EUROPEAN PATENT APPLICATION

(11) **EP 1 195 804 A1**
(43) Date of publication of application: **10.04.2002**
(21) Application number: 01901449.7
(22) Date of filing: 19.01.2001
(51) Int. Cl.: H01L 21/322

(54) **METHOD FOR PRODUCING SILICON EPITAXIAL WAFER**

(30) Priority: 26.01.2000 JP 2000017479
(71) Applicant: Shin-Etsu Handotai Co., Ltd, Tokyo 100-0005 (JP)
(72) Inventor: TAKENO, Hiroshi, Shin-Etsu Handotai CO., Ltd., Annaka-shi, Gunma 379-0196 (JP)
(74) Representative: Grünecker, Kinkeldey, Stockmair & Schwanhäusser Anwaltssozietät
(86) International application number: JP0100330
(87) International publication number: WO0156071

(57) **Abstract**

There is provided a novel manufacturing process for an epitaxial wafer having an IG ability, wherein heat treatment is applied at a temperature in a range of from 450°C to 750°C to an epitaxial wafer in which oxygen precipitation nuclei are reduced in an epitaxial growth step so as to form new oxygen precipitation nuclei therein, and oxygen precipitation proceeds in a device fabrication process subsequent to the heat treatment, especially oxide precipitates being effectively increased even when a wafer with a comparatively low oxygen concentration is used as a silicon substrate. A heat treatment at a temperature in a range of from 450°C to 750°C is applied to a silicon epitaxial wafer obtained by forming an epitaxial layer on a silicon substrate with an interstitial oxygen concentration in a range of from 4 x 10¹⁷/cm³ to 10 x 10¹⁷/cm³ at a temperature of 1000°C or higher.

## Description

### Technical Field

The present invention relates to a manufacturing process for a silicon epitaxial wafer having an internal gettering ability.

### Background Art

In the prior art, as a semiconductor wafer on which semiconductor devices such as ICs and LSIs are generally fabricated, there has been used a silicon single crystal wafer (a CZ silicon mirror-finished wafer) that is manufactured by a procedure in which a wafer is cut off from a silicon single crystal grown by means of a Czochralski method (a CZ method) and a surface of the wafer is mirror-polished. Interstitial oxygen is supersaturated in a silicon single crystal grown by means of the CZ method and precipitated to form oxygen precipitation nuclei during a thermal history from solidification till being cooled to room temperature in the crystal pulling process. When a silicon single crystal wafer is subjected to heat treatment in a fabrication process for IC or the like, the oxygen precipitation nuclei grow to proceed oxygen precipitation and thereby, microdefects caused by oxide precipitates are generated in the internal region of the semiconductor wafer.

When such microdefects caused by oxide precipitates are present in the internal region (the bulk region) of a semiconductor wafer, the microdefects preferably work as gettering sites that capture heavy metal impurities and others by an action of a so-called internal gettering (IG). However, it has been known that when such microdefects are present in a device formation region in the vicinity of a front surface of a semiconductor wafer, characteristics of a device fabricated in the region are degraded, which directly exerts a bad influence upon a product yield.

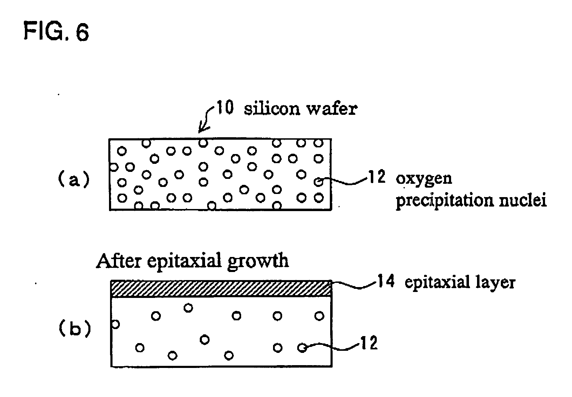

In order to achieve a defect-free region for device formation in the vicinity of a front surface of a semiconductor wafer, demands have been piled up for epitaxial wafers each manufactured by depositing silicon single crystal on a CZ silicon mirror finished wafer (hereinafter may be referred to as "silicon wafer" or "silicon substrate") by means of vapor phase growth instead of the CZ silicon mirror finished wafer. In a CZ silicon mirror finished wafer 10, as shown in FIG. 6(a), since many of oxygen precipitation nuclei 12 are formed during a period from solidification till being cooled down to room temperature in a crystal pulling step, the precipitation nuclei grow to proceed oxygen precipitation in a fabrication process of a semiconductor device.

In an epitaxial wafer 16 with an epitaxial layer 14 grown, since an epitaxial growth step is performed at a high temperature of 1000°C or higher, many of oxygen precipitation nuclei 12 formed in a pulling step of a CZ crystal are, as shown in FIG. 6(b), dissolved into solid solution in the epitaxial growth step to suppress oxygen precipitation in the fabrication process of a semiconductor device compared with a CZ mirror wafer. Accordingly, an epitaxial wafer has a problem that an IG ability is reduced. In the prior art to solve this problem, there can be named external gettering (EG) methods such as a sand blast (SB) method and a method in which a polycrystalline silicon film is deposited on a back surface of a wafer (PBS method).

When such an EG method is adopted, a formation region (a front surface of a wafer) for a semiconductor device is far from gettering sites (a back surface of the wafer), which problematically requires a time for capturing impurities. Such a situation becomes more conspicuous when adopting a low temperature fabrication process for a semiconductor device since a necessary time is longer for impurities to diffuse to the back surface of the wafer.

It is, therefore, preferable that an IG method is employed in which distances are small between a formation region (a front surface of a wafer) for a semiconductor device and gettering sites (the bulk). In an epitaxial wafer, however, oxygen precipitation in a fabrication process of a semiconductor device is suppressed compared with a CZ mirror wafer, resulting in a problem of reduction in an IG ability.

Meanwhile, it is known that JP2725460 discloses a technique applying an IG treatment to an epitaxial wafer. However, according to a technique described in JP2725460, using a silicon substrate with a considerably high oxygen concentration (16 x 10¹⁷ to 19 x 10¹⁷/cm³) as an object, oxygen precipitation occurs in excess and there is likely to occur reduction in substrate strength. Furthermore, according to the known technique, using a wafer highly doped with Sb as an object, it is necessary to pull a crystal with a high Sb concentration. In the pulling operation, there has arisen a problem that an oxygen concentration is drastically reduced along the total length of a pulled crystal from the top to the bottom because of evaporation of oxygen from the silicon melt. Therefore, if wafer fabrication is limited to such a wafer with a high oxygen concentration, wafers can be obtained only from a very small part of a pulled crystal, resulting in a new problem of deterioration in productivity.

### Disclosure of the Invention

The present invention has been made in light of the problems in the prior art and it is an object of the present invention to provide a novel manufacturing process for an epitaxial wafer having an IG ability, wherein heat treatment is applied at a temperature in a range of from 450°C to 750°C to an epitaxial wafer in which oxygen precipitation nuclei are reduced in an epitaxial growth step so as to form new oxygen precipitation nuclei therein, and oxygen precipitation proceeds in a device fabrication process subsequent to the heat treatment, especially the oxide precipitates being effectively increased even when a wafer with a comparatively low oxygen concentration is used as a silicon substrate.

A manufacturing process for a silicon epitaxial wafer of the present invention comprises the steps of forming an epitaxial layer on a silicon substrate with an interstitial oxygen concentration in a range of from 4 x 10¹⁷/cm³ to 10 x 10¹⁷/cm³ at a temperature of 1000°C or higher to obtain a silicon epitaxial wafer; and applying heat treatment to the silicon epitaxial wafer at a temperature in a range of from 450°C to 750°C. It is more preferable that the interstitial oxygen concentration is in a range of from 6 x 10¹⁷/cm³ to 10 x 10¹⁷/cm³. Unless the interstitial oxygen concentration reaches 4 x 10¹⁷ atoms/cm³ and preferably to 6 x 10¹⁷ atoms/cm³, an oxygen precipitation nucleus is hard to be formed. If the interstitial oxygen concentration exceeds 10 x 10¹⁷ atoms/cm³, many of oxygen precipitation nuclei are formed; therefore, oxygen precipitation becomes in excess in a device fabrication process, making a possibility to cause wafer deformation to be higher. Note that the unit of an interstitial oxygen concentration is expressed using a criterion of Japan Electronic Industry Development Association (JEIDA).

It is more preferable that the heat treatment temperature is in a range of from 500°C to 700°C. If the heat treatment temperature is lower than 450°C and preferably lower than 500°C, diffusion of interstitial oxygen becomes extremely slower, thereby making oxygen precipitation nuclei hard to be formed. If the heat treatment temperature exceeds 750°C and preferably 700°C, a degree of supersaturation of interstitial oxygen becomes lower to make oxygen precipitation nuclei hard to be formed.

It is preferable that a time of heat treatment at a temperature in the range of from 450°C to 750°C is in a range of from 30 minutes to 24 hours. For formation of oxygen precipitation nuclei it is required to perform the heat treatment for at least 30 minutes, while to perform the heat treatment in excess of 24 hours causes a problem of reduction in productivity. A preferable range of the heat treatment time is between 1 and 8 hours.

Furthermore, in a process of the present invention, oxygen precipitation nuclei can be more effectively formed by application of heat treatment at a temperature in the range of from 450°C to 750°C to an epitaxial wafer manufactured using an N-type silicon substrate (on which an epitaxial layer is formed) with a resistivity of 0.02 Ω-cm or lower, which has been known as a substrate that oxygen is hard to be precipitated therein or a P-type silicon substrate with a resistivity of 0.02 Ω-cm or lower. It is preferable to employ boron (B), arsenic (As) or antimony (Sb) as a dopant in the substrate.

### Brief Description of the Drawings

FIG. 1 shows are sectional views of a silicon wafer in steps of a manufacturing process for an epitaxial wafer of the present invention shown according to the order in which the process advances;
FIG. 2 is a graph showing a relationship between a heat treatment temperature and a bulk defect density of an epitaxial wafer in Experimental Example 1;
FIG. 3 is a graph showing a relationship between a heat treatment temperature and a bulk defect density of an epitaxial wafer in Experimental Example 2;
FIG. 4 is a graph showing a relationship between a heat treatment temperature and a bulk defect density of an epitaxial wafer in Experimental Example 3;
FIG. 5 is a graph showing a relationship between a heat treatment temperature and a bulk defect density of an epitaxial wafer in Experimental Example 4; and
FIG. 6 shows sectional views of a silicon wafer in steps of a prior art manufacturing process for an epitaxial wafer shown according to the order in which the process advances.

### Best Mode for Carrying out the Invention

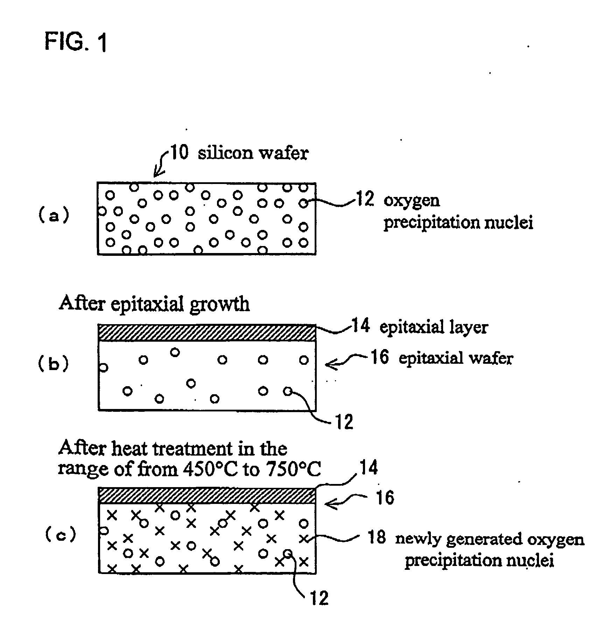

Description will be given of embodiments of the present invention below on the basis of FIG. 1 among the accompanying drawings.

FIGs. 1(a) and 1(b) are similar to the aforementioned prior art manufacturing process for an epitaxial wafer and many of oxygen precipitation nuclei 12 formed in a pulling step of a CZ crystal are present in a silicon wafer 10 (FIG. 1(a)). When an epitaxial layer 14 is grown on the silicon wafer 10 at a high temperature of 1000°C or higher, for example, on the order of 1100 to 1150°C, in an epitaxial growth step, many of oxygen precipitation nuclei 12 are dissolved into solid solution to reduce the number of the oxygen precipitation nuclei 12 by a large margin (FIG. 1(b)).

A characteristic step of the present invention, as shown in FIG. 1(c), is to newly generate many of oxygen precipitation nuclei 18 by applying a heat treatment at a temperature in a range of from 450°C to 750°C for at least 30 minutes to an epitaxial wafer 16, in which the oxygen precipitation nuclei 12 have been reduced. By generating many of new oxygen precipitation nuclei 18 in such a way, oxygen precipitation proceeds in a subsequent device fabrication process, thereby obtaining an epitaxial wafer without reduction in an IG ability.

### Examples

The present invention will be further described concretely by way of the following experimental examples. Note that an oxygen concentration of any of silicon substrates used in the experimental examples is obtained by converting a measured value from the inert gas fusion method on the basis of a mutual relationship between the Fourier-Transform infrared spectroscopy and the inert gas fusion method obtained using a substrate with an ordinary resistivity (1 to 20 Ω-cm), and the unit of the oxygen concentration is expressed using a criterion of Japan Electronic Industry Development Association (JEIDA).

### (Experimental Example 1)

B doped silicon substrates with resistivities of about 10 Ω-cm, 0.016 Ω-cm and 0.008 Ω-cm were prepared. A diameter of each of the silicon substrates was 8 inches, a crystal orientation thereof was <100> and initial oxygen concentration thereof was in the range of from 6 x 10¹⁷ to 8 x 10¹⁷/cm³ (12 to 16 ppma). Silicon single crystal was deposited on each of the silicon substrates at 1100°C by epitaxial growth (hereinafter may be referred to as "epi-growth") to manufacture an epitaxial wafer. The epitaxial wafers were heat treated at a temperature between 400°C and 800°C for 4 hours. Thereafter, the epitaxial wafers were subjected to oxygen precipitation heat treatment under conditions of 800°C/4 hours + 1000°C/16 hours, and were evaluated on a bulk defect density using the infrared laser scattering tomography. An apparatus of model MO-401 made by Mitsui Mining & Smelting Co., Ltd. was used for the infrared laser scattering tomography.

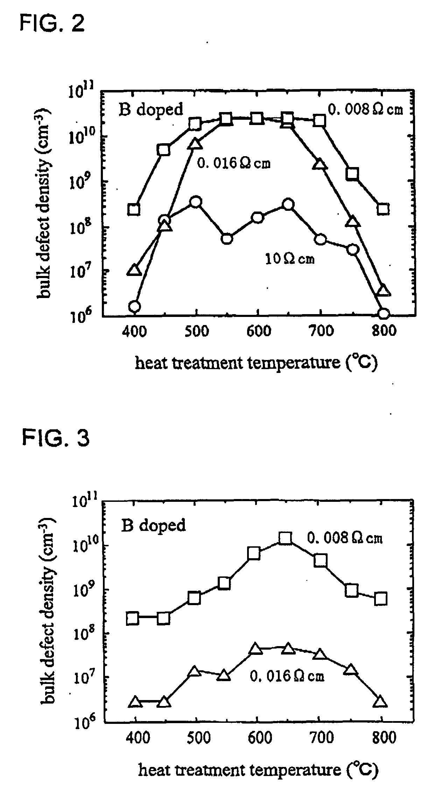

In FIG. 2, there is shown a relationship between a heat treatment temperature and a bulk defect density after epi-growth. It can be seen from FIG. 2 that the bulk defect density rises depending on the temperature, and the density is higher in the range of from 450 to 750°C, especially from 500 to 700°C. Furthermore, the lower the substrate resistivity, the higher the effect of the heat treatment. About 2 x 10¹⁰/cm³ of the bulk defect density value is the upper detection limit under the present measuring conditions. In case of a density higher than this upper detection limit, the bulk defects cannot be distinguished from each other because of overlapping of the defects.

### (Experimental Example 2)

The epitaxial wafers having substrate resistivities of 0.016 Ω-cm and 0.008 Ω-cm among the epitaxial wafers prepared in Experimental Example 1 were subjected to heat treatment at a temperature between 400°C and 800°C for 30 minutes. Thereafter, in the similar manner to Example 1, the epitaxial wafers were subjected to the oxygen precipitation heat treatment under conditions of 800°C/4 hours + 1000°C/16 hours, and were evaluated on a bulk defect density using the infrared laser scattering tomography.

In FIG. 3, there is shown a relationship between a heat treatment temperature and a bulk defect density after epi-growth. The bulk defect density rises depending on the temperature. Furthermore, the lower the substrate resistivity, the higher the effect of the heat treatment. It can also be understood on the basis of the above findings that even the heat treatment time of 30 minutes after epi-growth is sufficiently effective.

### (Experimental Example 3)

As doped silicon substrates with resistivities of 0.012 Ω·cm and 0.009 Ω-cm were prepared. A diameter of each of silicon substrates was 6 inches, a crystal orientation thereof was <100> and initial oxygen concentrations thereof was in the range of from 7 x 10¹⁷ to 9 x 10¹⁷/cm³ (14 to 18 ppma). Silicon single crystal was deposited on each of the silicon substrates at 1100°C by epitaxial growth to manufacture an epitaxial wafer. The epitaxial wafers were heat treated at a temperature between 400°C and 800°C for 4 hours. Thereafter, the epitaxial wafers were subjected to oxygen precipitation heat treatment under conditions of 800°C/4 hours + 1000°C/16 hours, and were evaluated on a bulk defect density using the infrared laser scattering tomography.

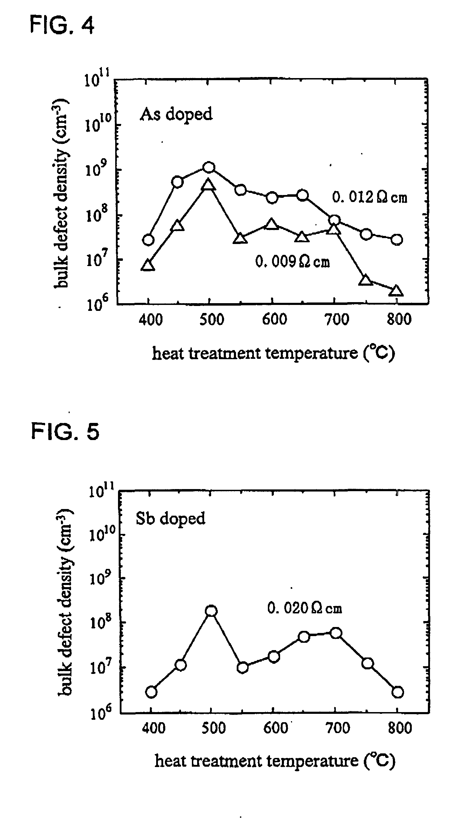

In FIG. 4, there is shown a relationship between a heat treatment temperature and a bulk defect density after epi-growth. The bulk defect density rises depending on the temperature. It can be understood on the basis of the above findings that the heat treatment after epi-growth is also effective for an As doped substrate.

### (Experimental Example 4)

Sb doped silicon substrates with a resistivity of 0.02 Ω-cm were prepared. A diameter of each of the silicon substrates was 8 inches, a crystal orientation thereof was <100> and initial oxygen concentrations thereof was in the range of from 8 x 10¹⁷ to 10 x 10¹⁷/cm³ (16 to 20 ppma). Silicon single crystal was deposited on each of the silicon substrates at 1100°C by epitaxial growth to manufacture an epitaxial wafer. The epitaxial wafers were heat treated at a temperature between 400°C and 800°C for 12 hours. Thereafter, the epitaxial wafers were subjected to oxygen precipitation heat treatment under conditions of 800°C/4 hours + 1000°C/16 hours, and were evaluated on a bulk defect density using the infrared laser scattering tomography.

In FIG. 5, there is shown a relationship between a heat treatment temperature and a bulk defect density after epi-growth. The bulk defect density rises depending on the temperature. It can be understood on the basis of the above findings that the heat treatment after epi-growth is also effective for an Sb doped substrate.

### (Comparative Example 1)

Epitaxial wafers were prepared under the similar conditions to Experimental Examples 1 to 4. Thereafter, the epitaxial wafers were subjected to oxygen precipitation heat treatment under conditions of 800°C/4 hours + 1000°C/32 hours without performing the heat treatment at a temperature between 400°C and 800°C, and were evaluated on a bulk defect density using the infrared laser scattering tomography. As a result, bulk defect densities were of the order of 10⁶/cm³ or lower in any epitaxial wafers with the resistivities.

It can be seen from the results of Experimental Examples 1 to 4 and Comparative Example 1 that the bulk defect density of the silicon epitaxial wafers can be raised by applying heat treatment thereto at a temperature in the range of from 450°C to 750°C, preferably from 500°C to 700°C. It can also be seen that the heat treatment is effective in case of any kind of dopant. Furthermore, it can be seen in case of B doped silicon substrate that the lower the substrate resistivity, the higher the effect of the heat treatment.

### Capability of Exploitation in Industry

According to the present invention, as described above, there can be manufactured an epitaxial wafer having an IG ability, especially capable of effectively increasing oxide precipitates even when a wafer with a comparatively low oxygen concentration is used as a silicon substrate by applying heat treatment thereto at a temperature in the range of from 450°C to 750°C.

## Claims

1. A manufacturing process for a silicon epitaxial wafer comprising the steps of:
forming an epitaxial layer on a silicon substrate with an interstitial oxygen concentration in a range of from 4 x 10¹⁷/cm³ to 10 x 10¹⁷/cm³ at a temperature of 1000°C or higher to obtain a silicon epitaxial wafer; and
applying heat treatment to the silicon epitaxial wafer at a temperature in a range of from 450°C to 750°C.

2. The manufacturing process for a silicon epitaxial wafer according to claim 1, wherein the interstitial oxygen concentration is in a range of from 6 x 10¹⁷/cm³ to 10 x 10¹⁷/cm³.

3. The manufacturing process for a silicon epitaxial wafer according to claim 1 or 2, wherein the heat treatment temperature is in a range of from 500°C to 700°C.

4. The manufacturing process for a silicon epitaxial wafer according to any of claims 1 to 3, wherein a substrate resistivity of the epitaxial wafer is 0.02 Ω-cm or lower.

5. The manufacturing process for a silicon epitaxial wafer according to any of claims 1 to 4, wherein a dopant in a substrate of the silicon epitaxial wafer is boron, arsenic or antimony.
